# EUROPÄISCHE PATENTSCHRIFT

(11) **EP 2 992 947 B1**
(45) Veröffentlichungstag und Bekanntmachung des Hinweises auf die Patenterteilung: **01.03.2023**
(21) Anmeldenummer: 15002482.6
(22) Anmeldetag: 21.08.2015
(51) Int. Cl.: B01D 67/00, B01D 71/72

(54) **VERFAHREN ZUR HERSTELLUNG MIKROPORÖSER ORGANISCHER MEMBRANEN, MIKROPORÖSE ORGANISCHE MEMBRANEN UND DEREN VERWENDUNG**
METHOD FOR THE PREPARATION OF MICROPOROUS ORGANIC MEMBRANES, MICROPOROUS ORGANIC MEMBRANES AND USE OF SAME
PROCEDE DE FABRICATION DE MEMBRANES ORGANIQUES MICRO-POREUSES, MEMBRANES ORGANIQUES MICRO-POREUSES ET LEUR UTILISATION

(30) Priorität: 25.08.2014 DE 102014112088
(43) Veröffentlichungstag der Anmeldung: 09.03.2016
(73) Patentinhaber: Karlsruher Institut für Technologie, 76131 Karlsruhe (DE)
(72) Erfinder: Franzreb, Matthias, 76185 Karlsruhe (DE); Bräse, Stefan, 53842 Troisdorf (DE); Wöll, Christof, 76185 Karlsruhe (DE); Tsotsalas, Manuel, 76133 Karlsruhe (DE); Lindemann, Peter, 64521 Gross-Gerau (DE)

(56) Entgegenhaltungen:
- US-A1- 2009 047 517
- MANUEL TSOTSALAS ET AL: "Fabrication of Highly Uniform Gel Coatings by the Conversion of Surface-Anchored Metal-Organic Frameworks", JOURNAL OF THE AMERICAN CHEMICAL SOCIETY, Bd. 136, Nr. 1, 8. Januar 2014 (2014-01-08), Seiten 8-11, XP055245783, US ISSN: 0002-7863, DOI: 10.1021/ja409205s
- V. MUGNAINI ET AL: "Electrochemical investigation of covalently post-synthetic modified SURGEL coatings", CHEMICAL COMMUNICATIONS - CHEMCOM, Bd. 50, Nr. 76, 29. Juli 2014 (2014-07-29) , Seite 11129, XP055245679, GB ISSN: 1359-7345, DOI: 10.1039/C4CC03521F
- DINGCAI WU ET AL: "Design and Preparation of Porous Polymers", CHEMICAL REVIEWS, Bd. 112, Nr. 7, 11. Juli 2012 (2012-07-11) , Seiten 3959-4015, XP055198477, ISSN: 0009-2665, DOI: 10.1021/cr200440z

## Beschreibung

Die Erfindung betrifft ein Verfahren zur Herstellung mikroporöser organischer Membranen, die damit hergestellten mikroporösen organischen Membranen und deren Verwendung.

Mikroporöse organische Membranen (POF-Membranen), engl. Porous Organic Frameworks (POF), sind organische Feststoffe mit hoher Porosität, welche aus molekularen Bausteinen aufgebaut sind die über kovalente Bindungen miteinander verknüpft sind. POF sind mikroporöse Netzwerke mit einer Porengröße bis zu 10 nm. Sie ziehen seit ihrer Entdeckung ein weit verbreitetes"Interesse auf sich. Zu ihren herausragenden Eigenschaften zählen hohe Gasspeicherkapazitäten für Wasserstoff und Kohlenwasserstoffe sowie Anwendungspotenziale in den Bereichen Gastrennung, Sensorik und Katalyse.

Wu *et al.* beschreiben in einem Review die Fortschritte, die seit 2005 bei der Entwicklung von Strategien für die Herstellung poröser Polymere erzielt wurden, einschließlich der Direct Templating-, Block Copolymer-Self-Assembly- und Direktsynthesemethoden, und stellen dar, wie diese Methoden zur Gestaltung, Konstruktion und Anpassung der Porenstrukturen und zur Anpassung der Funktionalitäten innerhalb des Gerüstes oder auf der Porenoberfläche genutzt werden können (D. Wu et al., Chem. Rev. 2012, 112,'7, 3959-4015).

Die Herstellung von POF erfolgt durch solvothermale bzw. hydrothermale Verfahren, bei denen aus einer Mischung der Ausgangssubstanzen Pulver-Materialien ausgefällt werden. Für viele Applikationen ist der direkte Einsatz dieser pulverförmigen Materialien jedoch nicht möglich und macht die Beschichtung von Substraten mit POF erforderlich.

Mit dem "Lage-für-Lage"-Verfahren werden qualitativ hochwertige Beschichtungen erzeugt. Die Herstellung von Multilagen-Oberflächenbeschichtungen aus unterschiedlichen Materialien wird durch zyklisches Eintauchen des Substrats in die Lösungen dieser Substanzen (layer-by-layer Verfahren) erreicht. Auf diese Weise wurden beispielsweise von G. Decher et al. (Science 1997, 277, 1232-1237) Polyelektrolyt-Schichten hergestellt. Hierbei werden attraktive Coulomb-Wechselwirkungen zwischen Monolagen aus entgegengesetzt geladenen Polyelektrolytmolekülen ausgenutzt, um stabile Schichtsysteme aufzubauen. Nach Ausbildung einer monomolekularen Schicht der Spezies einer Ladung tritt eine elektrostatische Abstoßung auf, die die Anlagerung weiterer Moleküle gleicher Ladung verhindert. Wird das Substrat anschließend in eine zweite Lösung mit einem entgegengesetzt geladenen Polyelektrolyten getaucht, kommt es zu einer elektrostatischen Anbindung dieser Moleküle an die Oberfläche. Durch wechselweises Eintauchen in die beiden Lösungen bildet sich so eine in Dicke und chemischer Zusammensetzung wohldefinierte Schicht aus. Die Polyelektrolytmoleküle sind dabei weder untereinander kovalent gebunden, noch bilden sie eine permanent poröse Struktur.

Die US2009047517 A1 offenbart die Herstellung von Polymerfilmen mit einer Porengröße von 5 - 50 nm, bevorzugt von 10 - 50 nm, die aus mehreren Lagen eines flexiblen Polymers bestehen und kovalent mit einem Crosslinker ver̋knüpft sind, der zyklische Reste aufweist. Der Polymerfilm kann auf einem Substrat aufgebracht sein, das porös sein kann und entfernbar ist. Durch die Verknüpfung der Polymerschichten durch den Crosslinker erhalten die Polymerfilme die notwendige Stabilität, sodass sie auch ohne ein Substrat (eine Opferschicht) nicht kollabieren. Das Lage-für-Lage Wachstum von dünnen POF-Schichten, die z.B. auf selbstassemblierten Monolagen (SAM) auf Metall-Oberflächen aufgebaut wurden, wurde erstmals in einer Publikation von Kim et al. (Macromolecules, 2011, 44, 7092) demonstriert. Hierbei konnte z.B. das kontrollierte und selektive Wachstum von POF auf 3-Aminopropyltriethoxysilane (APTES) SAM gezeigt werden. Die POF bestehen aus den Bausteinen Tetrakis(4-aminophenyl) methane (TAPM) und Tetrakis(4-isocyanatophenyl)methane (TIPM) . Es wurde zwar eine gleichmäßige Beschichtung von Substraten erreicht, Defektstellen/Poren zu überdecken ist jedoch mit großen Nachteilen verbunden. Das Verschließen dieser Defektstellen/Poren erfordert, wie von Qian et al. (Langmuir, 2012, 28, 17803) gezeigt, eine sehr große Anzahl von Lagen und ein Zuwachsen der Poren, dies führt zur Ausbildung einer dickeren Membran und damit zu einer signifikanten Abnahme der Permeanz für die Zielmoleküle.

Tsotsalas *et al.* beschreiben die Herstellung von hochporösen, kovalent gebundenen 3D-Polymerfilmen mit homogener Dicke. Hierbei werden SURMOFs eingesetzt, die aus einem auf einer Organothiolat-Schicht aufgebrachten Gerüst aus 2,2'-Diazido-4,4'-stilbendicarbonsäure und Kupferionen bestehen und aus denen durch eine innere Quervernetzung mit dem Crosslinker Trimethylethantripropiolat und anschließendem Herauslösen der Kupferionen mit EDTA SURGEL-Membranen gebildet werden. In Tsotsalas *et al.* werden Porengrößen von 10 - 20 nm diskutiert und als Beispiel eine Zellkulturstudie angeführt, in der das SURGEL mit Arabinose beladen wurde (Tsotsalas et al., JACS 2014, 136, 8-11). Mugnaini *et al.* beschreiben die Verwendung einer Thiol-Alkin-Kupplungsreaktion, um ein Ferrocenylderivat kovalent mit den Porenwänden einer vollständig organischen, porösen Polymerbeschichtung (SURGEL) zu verbinden. Das mesoporöse SURGEL erwies sich nach dem Einbau der Ferrocenylalkylketten innerhalb der SURGEL-Poren weiterhin permeabel für gelöstes Ferrocen (Mugnaini et al., ChemComm, 2014, 50, 11129-11131).

Aufgabe der vorliegenden Erfindung war es also, ein Verfahren bereitzustellen, das die Nachteile des Standes der Technik überwindet. Insbesondere liegt der vorliegenden Erfindung die Aufgabe zugrunde, ein Verfahren zur Herstellung möglichst dünner freistehender mikroporöser organischer Membranen mit wenigen bis keinen Defektstellen vorzuschlagen. Im Unterschied zum Stand der Technik soll ein einfaches, technisch unaufwändiges Verfahren gezeigt werden, das zu mikroporösen organischen Membranen mit hoher chemischer und thermischer Stabilität führt.

Diese Aufgabe wird im Hinblick auf das Verfahren durch die Merkmale des *Anspruchs 1* gelöst, in Hinblick auf die Membran durch die Merkmale des Anspruchs 7 und auf die Verwendung der Membran durch die Merkmale der Ansprüche 8 bis 10. Die Unteransprüche beschreiben jeweils vorteilhafte Ausgestaltungen der Erfindung.

Diese Aufgabe wird durch ein Verfahren zur Herstellung von mikroporösen organischen POF-Membranen enthaltend mindestens zwei verschiedene organische Verbindungen, wobei mindestens eine der organischen Verbindungen mindestens zwei funktionelle Gruppen und mindestens eine der weiteren organischen Verbindungen mindestens drei funktionelle Gruppen aufweist, mit den folgenden Verfahrensschritten gelöst:
a) Bereitstellen einer Opferschicht mit einer Vielzahl gleicher funktioneller Gruppen
b) Aufbringen einer ersten Lage einer ersten organischen Verbindung durch Reaktion mit den funktionellen Gruppen der Opferschicht
c) Aufbringen einer ersten Lage einer zweiten organischen Verbindung durch Reaktion mit mindestens einer der funktionellen Gruppen der organischen Verbindungen der ersten Lage
d) Auflösen der Opferschicht
e) Entnahme der POF-Membran,
wobei mindestens eine der funktionellen Gruppen einer Lage oder der Opferschicht mit mindestens einer der funktionellen Gruppen der nachfolgenden Lage reagiert und die funktionellen Gruppen der aufeinanderfolgenden Lagen komplementär sind und/oder durch Schutzgruppen geschützt sind, gelöst , wobei die Opferschicht und die erhaltene POF-Membran die in Anspruch 1 definierten Merkmale aufweisen.

Um Folien mit einer gewünschten Dicke herzustellen, werden zwischen den Verfahrensschritten c) und d) folgende zusätzliche Verfahrensschritte durchgeführt:
c i) Aufbringen einer weiteren Lage der ersten oder einer weiteren organischen Verbindung mit mindestens zwei gleichen oder verschiedenen funktionellen Gruppen durch Reaktion mit mindestens einer funktionellen Gruppe der Lage aus Schritt c) und
c ii) Aufbringen einer weiteren Lage der zweiten oder einer weiteren organischen Verbindung mit mindestens zwei funktionellen Gruppen durch Reaktion mit den funktionellen Gruppen der Lage aus Schritt c i) und/oder
c iii) Wiederholung der Schritte c, c i und/oder c ii, bis eine gewünschte Schichtdicke erreicht ist.

Das erhaltene Produkt, die mikroporöse organische Membran (POF-Membran) weist mindestens zwei verschiedene organische Verbindungen auf, wobei mindestens eine der Verbindungen mindestens zwei und mindestens eine der mindestens einen weiteren Verbindung mindestens drei funktionelle Gruppen aufweisen und mindestens eine der funktionelle Gruppen der jeweils vorhergehenden Lagen mit der mindestens einer funktionellen Gruppe der nachfolgenden Lage verknüpft ist. Durch den vorgeschlagenen Prozess lassen sich daher erstmalig mikroporöse organische Membranen erzeugen, die freistehend vorliegen und aus hochporösen Schichten, aus POFs, bestehen. Die Einsatzmöglichkeiten dieser Membranen reichen weit über den Bereich einfacher dünner Polymerschichten hinaus und umfassen u.a. Halbleiter, Membranen, Sensoren und optische Komponenten. Auch lassen sich die so erzeugten Membranen beliebige auf Substrate übertragen.

Im Rahmen der vorliegenden Erfindung bedeutet der Begriff "Raumtemperatur" eine Temperatur von 16 bis 25°C. Sofern nichts anderes angegeben wird, werden die angeführten Reaktionen bzw. Verfahrensschritte bei Normaldruck/Atmo-sphärendruck, d.h. bei 1013 mbar, durchgeführt.

Im Rahmen der vorliegenden Erfindung schließt die Formulierung "und/oder" sowohl jede beliebige als auch alle Kombinationen der in der jeweiligen Auflistung genannten Elemente ein.

Die Abkürzung "v/v" bedeutet im Rahmen der vorliegenden Erfin-dung "Volumen der betreffenden Komponente je Gesamtvolumen des Gemischs".

Im Rahmen der vorliegenden Offenbarung umfasst der Begriff "mikroporöses" Material mit einem mittleren Porendurchmesser in einem Bereich von 0 nm - 10 nm, bevorzugt von 0,1 nm - 5 nm und besonders bevorzugt von 0,2 - 2 nm, insbesondere gemessen mittels Bestimmung der Durchlässigkeit von Gasen mit Molekülen verschiedener Größe. Die Porengröße wird durch den späteren Anwendungszweck vorgegeben. So muss die Porengröße bei z.B. Anwendung in der Gastrennung so eingestellt werden, dass das mindestens ein Teil der betreffenden Gasmoleküle durch die Folie hindurchwandern kann.

Die Bezeichnung porous organic framework (POF) bezeichnet einen porösen Feststoff, welcher durch Verknüpfung von organischen Moleküle entsteht; ein metal-organic framework (MOF) ist ein poröser Feststoff, in dem organischen Liganden über Metall Ionen oder Clustern miteinander verknüpft sind. Dementsprechend bezeichnet surface anchored Metal-Organic Framework (SURMOF) ein MOF, welcher auf einem Substrat aufgewachsen wurde.

Die Bezeichnung mikroporöse organische Membran und POF-Membran sind äquivalent.

Ausgestaltungen können frei miteinander kombiniert werden..

Ausgangspunkt der Erfindung war die Idee, hybride POF/SURMOF-Schichten auf Oberflächen zu erzeugen, um so die Stabilität von SURMOFs insbesondere in wässrigen Medien zu erhöhen.. Bei Stabilitätsuntersuchungen in Wasser zeigte sich jedoch, dass sich die POF Beschichtungen bei Zugabe von Komplexbildnern, Säuren oder Basen ablösen und sich auf diese Weise freistehende, homogene Membranen mit einer Dicke von mindestens 0,3 nm , bevorzugt mindestens 1nm bis zu maximal 1000 nm erzeugen lassen. Die Dicke der Membran lässt sich mittels AFM bestimmen, die Homogenität bezeichnet hier die Entstehung einer kontinuierlichen Membran ohne Defekte, was sich durch zyklische Voltametrie-Untersuchungen bestätigen lässt.

Das erfindungsgemäße Verfahren erlaubt die Herstellung von POF-Membranen mit folgenden Merkmalen:
i. Sie sind aus mindestens zwei verschiedenen rigiden bzw. starren, d.h. aromatische Bausteine aufweisenden Ausgangssubstanzen wobei mindestens eine der organischen Verbindungen mindestens zwei funktionellen Gruppen und mindestens eine der weiteren organischen Verbindungen mindestens drei funktionellen Gruppen aufweist, aufgebaut.
ii. Die POF-Membran zeigt eine homogene, kontinuierliche Schichtdicke, mit einer minimalen Schichtdicke von 0,3 nm.
iii. Die entstehende Schicht ist hochporös. mit einer Porengröße von 0,2 - 2 nm.
iv. Die Membran ist freistehend.
v. Die Membran kann asymmetrisch hergestellt werden (Multilagen-Membran), d.h. durch Verwendung von mehr als 2 verschiedenen organischen Verbindungen können mehr als 2 verschiedene Lagen erzeugt werden.

Der Aufbau der Membran erfolgt konsekutiv durch Aufbringen unterschiedlicher Lagen von Verbindungen mit mindesten zwei verschiedenen oder gleichen funktionellen Gruppen auf die jeweils vorhergehende Lage bzw. Opferschicht. Die jeweils nachfolgende Lage reagiert mit der vorhergehenden Lage, bevorzugt unter Ausbildung einer kovalenten Bindung. Dabei sind die funktionellen Gruppen zur Reaktion mit der vorhergehenden Lage und der nachfolgenden Lage gleich oder verschieden. Die funktionellen Gruppen der vorhergehenden und der nachfolgenden Lage zur Reaktion mit der sich dazwischen befindlichen Lage sind ebenfalls gleich oder verschieden.

Die verwendeten organischen Verbindungen sind in einer besonderen Ausgestaltung starr bzw. rigide, d.h. sie weisen aromatische Bausteine auf. Die Geometrie in Bezug auf ihre funktionellen Gruppen ist so ausgelegt, dass es sterisch nicht möglich ist, alle funktionellen Gruppen eines Moleküls mit den funktionellen Gruppen der vorhergehenden Lage reagieren zu lassen und so dass die funktionellen Gruppen möglichst weit voneinander entfernt positioniert sind. Verhindert werden soll eine Verbrückung, bzw. eine Absättigung der Oberfläche der vorhergehenden Lage, d.h. eine Reaktion aller verfügbaren funktionellen Gruppen der zuletzt aufgebrachten Lage mit den funktionellen Gruppen der vorhergehenden Lage.

Die Auswahl der Verbindung der jeweils nachfolgenden Lage ist abhängig von den funktionellen Gruppen der vorhergehenden Lage, d.h. die mindestens eine freie funktionelle Gruppe der Opferschicht bzw der vorhergehenden Lage sollen mit mindestens einer funktionellen Gruppe der Verbindung der nachfolgenden Lage reagieren, bevorzugt unter Ausbildung einer kovalenten Bindung, bevorzugt durch eine Reaktion, die wenige bis keine Nebenprodukte bildet.

Dazu sind in einer Ausgestaltung mindestens eine der funktionelle Gruppen der jeweils vorhergehenden Lagen oder der Opferschicht und mindestens eine der funktionellen Gruppen der nachfolgenden Lage zueinander komplementär, d.h. die funktionellen Gruppen sind zur Reaktion miteinander befähigt und/oder durch Schutzgruppen geschützt. Bevorzugte komplementäre Paarungen funktioneller Gruppen finden sich in Tabelle 1. In einer weiteren Ausgestaltung werden funktionelle Gruppen durch Zugabe eines Aktivierungsreagenz aktiviert werden, dabei werden in einer bevorzugten Ausgestaltung Aktivierungsmethoden ausgewählt aus folgender Liste eingesetzt:' Zugabe eines. Katalysators, Aktivierung eines Esters durch Zugabe esterspaltender Reagenzien, Aktivierung mittels Licht und/oder UV-Licht oder Zugabe eines radikalischen Initiators.

In einer anderen Ausgestaltung werden funktionelle Gruppen vor der Umsetzung mit der nachfolgenden Lage durch Reaktion mit einem bifunktionellen Baustein, eines mit mindestens zwei gleichen oder verschiedenen funktionellen Gruppen versehenen Moleküls, zur Reaktion gebracht. So werden z.B. neue funktionelle Gruppen, definierte Abstände oder auch definierte Fehlstände zwischen zwei Lagen eingebracht. Ist es sterisch nicht möglich, dass beide funktionellen Gruppen des bifunktionellen Bausteins mit der vorhergehenden Lage reagieren, werden in einer Ausgestaltung bifunktionelle Bausteine mit zwei gleiche funktionelle Gruppen verwendet, wie Dialdehyde, Diamine, Dicarbonsäuren, in einer Ausgestaltung ist dabei eine der beiden gleichen funktionellen Gruppen mit einer Schutzgruppe versehen.

In einer Ausgestaltung erfolgt die Umsetzung mindestens zwei verschiedener organischer Verbindungen, wobei mindestens eine der organischen Verbindungen zwei oder mehr funktionelle Gruppen und mindestens eine weitere drei oder mehr funktionelle Gruppen aufweist, wobei die funktionellen Gruppen eines Moleküls gleich oder verschieden sein können. In einer weiteren Ausgestaltung, wenn ein hoher Vernetzungsgrad gewünscht ist, wird mindestens eine organische Verbindung mit mehr als drei funktionellen Gruppen eingesetzt. Über die Kombination der organischen Verbindungen, genauer über die Anzahl an gleichen und/oder verschiedenen funktionellen Gruppen pro Molekül, kann der Vernetzungsgrad zwischen den einzelnen Lagen gesteuert werden. Eine hohe Anzahl an möglichst gleichen oder gleich reagierenden funktionellen Gruppen in den Molekülen aufeinanderfolgender Lagen führt aufgrund der höheren Reaktionswahrscheinlichkeit zu stark quervernetzten und damit stabilen Folien mit geringeren Porendurchmessern. Eine geringe Anzahl gleicher oder gleich reagierender funktioneller Gruppen in einem Molekül führt zu einer geringeren Anzahl an Querverbindungen und damit zu einem geringeren Vernetzungsgrad der aufeinanderfolgenden Lagen und damit zu einer instabileren, hochporöseren Folie mit größeren Porendurchmessern.

Eine Quervernetzung innerhalb einer Lage ist in einer Ausgestaltung nicht vorgesehen, da die Quervernetzung durch die Verbindungen der nachfolgenden Lage entsteht. Diese setzen sich zwischen die Verbindungen der vorhergehenden Lage und führen dadurch zu einer Quervernetzung. In dieser Ausgestaltung ist es bevorzugt, dass die verwendeten Komponenten/Verbindungen zum Aufbau der Membran mindestens drei gleiche, besonders bevorzugt mehr als drei gleiche, funktionelle Gruppen aufweisen. In einer anderen Ausgestaltung erfolgt die Quervernetzung durch Umsetzung mit einem zusätzlichen Linker, d.h. einer Verbindung, die über mindestens zwei verschiedene oder gleiche funktionelle Gruppen verfügt und in der Lage ist, mit den funktionellen Gruppen, die in der POF-Membran vorliegen zu reagieren. Dieser Linker reagiert mit den funktionellen Gruppen mindestens einer Lage. In einer weiteren Ausgestaltung reagiert der Linker mit den funktionellen Gruppen mehrerer verschiedener Lagen und führt somit zu einer intermolekularen Quervernetzung. In einer weiteren Ausgestaltung verfügen die Verbindungen der verschiedenen Lagen über mindestens zwei weitere funktionelle Gruppen, so dass eine Quervernetzung durch Reaktion der beiden zwei weiteren funktionellen Gruppen zwischen den Molekülen einer Lage untereinander geschieht.

Eine besonders hohe Quervernetzung wird erzielt, wenn die Moleküle einer Lage über mindestens 2 funktionelle, komplementäre Gruppen verfügen, die untereinander miteinander reagieren und zu einer kovalenten Bindung führen.

**Tabelle 1: Beispiele komplementärer funktioneller Gruppen**

| Funktionelle Gruppe vorhergehende Lage | Funktionelle Gruppe nachfolgende Lage (komplementäre funktionelle Gruppe) | Mögliche Reaktionen zur Anbindung an die funktionelle Gruppe der vorhergehenden Lage |
|---|---|---|
| R-SH | Alken oder Alkin | Thiol-en bzw. Thiolyne |
| R-NH₂ | R-COOH | Kondensationsreaktion (zu Ausbildung einer Amidbindung) |
| R-N₃ | R-C≡CH | 1,3-Dipolare Cycloaddition |
| R-C=CH-HC=CH₂ (ein Dien) | R-HC=CH₂ (ein Dienophil) | Diels-Alder-Reaktion ([4+2]-Cycloaddition) |
| R-C=CH | R'-C=C-X; Aryl-X (X=I, Cl, Br, OTf) | Sonogashira-Kupplung |
| R-Sn-R' | R"-X (X=I, Cl, Br, OTf) | Stille-Kupplung |
| R-X (X=I, Cl, Br, OTf) | R'-C=CH | Heck-Reaktion |
| R-BY₂ | R'-X (X=I, Cl, Br, OTf) | Suzuki-Kupplung |

Bei der Anbindung der nachfolgenden Lage an die vorhergehende Lage, bzw. die Opferschicht werden bevorzugt Reaktionen ausgewählt aus der nachfolgenden Liste eingesetzt: Trimerisierung von Isocyanatgruppen, Kondensation von Alkoholen und Carbonsäurechloriden, Nucleophile Substitution, Kreuzkupplungsreaktionen, wie Sonogashira-Hagihara Kupplung von Alkin und Halogen Monomeren oder Suzuki-Miyaura, Oxidative Eglinton Kupplung, "Click-Chemie", z.B. Kupfer-katalysierte Alkin-Azid Kupplung.

Die Reaktionsbedingungen wählt der Fachmann je nach ausgewählter Reaktion und den bisher verwendeten Ausgangsstoffen.

Die Herstellung der mikroporösen organischen Membranen, die mindestens zwei verschiedene organische Verbindungen enthält, erfolgt, in dem zunächst in einem Verfahrensschritt a) eine Opferschicht mit einer Vielzahl gleicher funktioneller Gruppen bereitgestellt.

Die Opferschicht zeichnet folgende Merkmale aus:
i. Sie lässt sich mit einem der nachfolgend genannten Verfahren auflösen und
ii. sie ist stabil gegenüber den Reaktionsbedingungen der Syntheseschritte zur Herstellung der Folie

Die Opferschicht besteht aus einem MOF und/oder SURMOF-Material, bevorzugt ausgewählt unter Cu-DA-SBDC oder C.u-DA-SBDC-dabco wie beschrieben M. Tsotsalas et al. J. Am. Chem. Soc. 2014, 136, 8-11.

In einem nächsten Schritt b) wird eine erste Lage der ersten organischen Verbindung mit mindestens drei gleichen oder unterschiedlichen funktionellen Gruppen durch Reaktion mindestens einer funktionellen Gruppe mit den funktionellen Gruppen der Opferschicht auf die Opferschicht aufgebracht. Die reagierenden funktionellen Gruppen der ersten organischen Verbindung und die nicht reagierenden funktionellen Gruppen der ersten organischen Gruppe können gleich oder verschieden sein.

Im darauf folgenden Schritt c) wird eine erste Lage der zweiten organischen Verbindung mit mindestens drei gleichen oder verschiedenen funktionellen Gruppen durch Reaktion mit mindestens einer funktionellen Gruppe der ersten Lage aus Schritt b) aufgebracht.

In einer Ausgestaltung schließen sich an Verfahrensschritt c) folgende Verfahrensschritte an:
Im Verfahrensschritt c i) wird eine weitere Lage der ersten oder einer Lage einer weiteren organischen Verbindung mit mindestens zwei gleichen oder verschiedenen funktionellen Gruppen durch Reaktion mit mindestens einer funktionellen Gruppe der Lage aus Schritt c) aufgebracht, woraufhin im fakultativen Verfahrensschritt c ii) eine weitere Lage der zweiten oder eine Lage einer weiteren organischen Verbindung mit mindestens zwei funktionellen Gruppen durch Reaktion mit den funktionellen Gruppen der Lage aus Schritt c i) aufgebracht wird.

Die Schritte c), c i) und/oder c ii) werden solange wiederholt, bis eine gewünschte Schichtdicke erreicht ist. In bevorzugten Ausgestaltungen der vorliegenden Erfindung werden die Schritte c i) und c ii) mindestens 1 mal, besonders bevorzugt mindestens 3 mal, insbesondere bevorzugt mindestens 5 mal, wiederholt.

Sobald die gewünschte Schichtdicke erreicht ist, wird im Verfahrensschritt d) die Opferschicht aufgelöst.

Die Auflösung erfolgt abhängig vom Material der Opferschicht und der Folie. Beim Auflösen der Opferschicht sollte die Folie nicht beschädigt oder chemisch aufgelöst werden. SURMOF- und MOF-Opferschichten lassen sich mit Komplexbildnern wie EDTA oder durch Änderung des pH-Wertes, bevorzugt durch Erhöhung des pH-Wertes auf über pH =11, auflösen.

Anschließend wird die POF-Membran entnommen.

Im Unterschied zu dem beschriebenen Stand der Technik zur Herstellung und Verarbeitung von POF Materialien beruht das vorgeschlagene Verfahren auf einem streng kontrollierten Reaktionsprozess mit einer sequentiellen Abfolge des Aufbringens verschiedener Lagen von organischen Verbindungen auf einer Opferschicht. Durch das Auflösen der Opferschicht kann so eine freistehende Membran erzeugt werden, die anschließend auf jedes beliebige Substrat übertragen werden kann. Die Membran weist eine definierte Dicke und mindestens eine, in einer anderen Ausgestaltung, verschiedene Funktionalisierungen bzw. in einer weiteren Ausgestaltung ein Funktionalisierungsgradienten auf. In einer Ausgestaltung weist die Membran eine durchgehend gleichbleibende Porositäten auf, in einer anderen Ausgestaltung einen Porositätsgradienten. In einer weiteren Ausgestaltung werden die Membranporen durch Ankuppeln von funktionellen Molekülen und/oder Molekülgruppen funktionalisiert. Das geschieht entweder während der Synthese der Folie oder postsynthetisch. Dazu wird in einer Ausgestaltung auf die vorletzte Lage der Folie eine Lage eines einfach funktionalisierten Moleküls oder eines flexiblen Molekül mit mehr als einer funktionellen Gruppe, dessen Flexibilität eine Reaktion fast aller, bevorzugt aller, funktionellen Gruppen mit den funktionellen Gruppen der vorhergehenden Lage ermöglicht, aufgebracht und/oder die letzte Lage der Folie wird mit funktionalen Gastmolekülen und/oder Partikeln beladen. Des Weiteren findet in einer Ausgestaltung eine Funktionalisierung durch Beladung der Poren der Folie mit Nanopartikeln statt oder durch Umsetzung noch freier funktioneller Gruppen innerhalb der Folie mit den gewünschten Substanzen zur Modifikation der Eigenschaften. Durch diese Funktionalisierung lassen sich die Eigenschaften der Folie ändern, so z.B. die Hydrophilität der Oberfläche der Folie.

Gegenüber dem Stand der Technik verwendet die vorliegende Erfindung ein Verfahren, bei dem stabile, homogene, großflächige, freistehende POF Membranen mit definierter Dicke, Funktionalität des Gerüsts und mit definierten Oberflächefunktionalisierungen inklusive asymmetrischen Janus-Typ Membranen hergestellt werden können, die auf jedes beliebige andere Substrate übertragen werden kann. Im Unterschied zum Stand der Technik stellt die Erfindung daher erstmals eine generelle Methode dar, um beliebige freistehende multifunktionale POF-Membranen herzustellen und diese auf beliebige Substrate zu übertragen.

Während die Produktion pulverförmiger POFs im Labormaßstab etabliert ist, stellt die Integration dieser Materialien als neuartige, nanoskalige Bausteine und Funktionseinheiten in technische Umgebungen nach wie vor eine große Herausforderung dar. Für den Einsatz als mikroporöse Beschichtung im Bereich der Katalyse oder für die chemische Sensorik, sowie für nanotechnologische Anwendungen als Nanomembran und um durch Aufbringen der Folie optische Effekte zu erzielen, ist die Herstellung von freistehenden mikroporösen organischen Membranen eine wichtige Voraussetzung. Besonders für die Anwendung als Membran zur Gastrennung, Wasseraufbereitung und/oder für die Nanofiltration werden ultradünne durchgehend mikroporöse organische Membranen aus chemisch inerten und mechanisch stabilen Bauteilen benötigt.

Die erfindungsgemäße mikroporöse organische Membran findet auch in Brennstoffzellen, Batterien und/oder für die chemische Katalyse als Protonenaustauschmembran oder zur Abtrennung von homogenen Katalysatoren Einsatz.

Des Weiteren lässt sich die Membran in organischen Leuchtdioden (OLEDs), organischen Feldeffekttransistoren/Dünnschichttransistoren (OFET) und organischen Solarzellen (OPV) verwenden.

Die Gastrennungseigenschaften solcher POF-Membranen beruht durch die hochvernetzten steifen Bausteine hauptsächlich auf der unterschiedlichen Permeabilität der Membran gegenüber unterschiedlich großen Molekülen, im Gegensatz zu normalen polymeren Membranen. Daher werden die Membranen auch als Molekularsieb verwendet. Die große Variationsmöglichkeit in Hinblick auf die chemische Zusammensetzung und die Porengeometrie (Form, Größe etc.) erlaubt es, die Membranen für gewünschte Anwendungen gezielt herzustellen.

Die Verbindungen, die als Ausgangsstoffen für die Herstellung der POF-Membran eingesetzt werden können sind insbesondere:

| | |
|---|---|
| alkyl-THB : | alkyl-1,2,4,5-tetrahydroxybenzene |
| CA : | cyanuric acid |
| CTC : | cyclotricatechylene |
| DAB : | 1,4-diaminobenzene |
| DAzB : | 1,4-diazidobenzene |
| DCB : | 1,4-dicyanobenzene |
| DCF : | 2,7-diisocyanate fluorine |
| DCN : | 2,6-dicyanonaphthalene |
| DCP : | 2,6-dicyanopyridine |
| DEB : | 1,4-diethynylbenzene |
| DEBP : | 4,4'-diethynylbiphenyl |
| DETH : | 2,5-diethoxyterephthalohydrazole |
| DIB : | 1,4-diiodobenzene |
| DIBP : | 4,4'-diiodobiphenyl |
| DMBPDC : | 3,3'-dimethoxy-4,4'-biphenylene diisocyanate |
| DPB : | diphenyl butadyenediborönic acid |
| HP : | 1-hexyne propiolate |
| HPCT : | 9.10-hydroxyphenanthrene cyclotrimer |
| HHTP : | 2,3,6,7,10,11-hexahydroxytriphenylene |
| MP : | methyl propiolate |
| N3-BDBA : | azide-appended benzenediboronic acid |
| NiPcTA : | nickel-phthalocyanice tetrakis(acetonide) |
| OH-Pc-Ni : | 2,3,9,10,16,17,23,24-octahydroxyphthalocyaninato)nickel(II) |
| OH-Pc-Zn : | 2, 3, 9, 10, 16, 17, 23, 24-octahydroxyphthalocyaninato)zinc |
| OH-Pc-Cu : | 2,3,9,10,16,17,23,24-octahydroxyphthalocyaninato)copper |
| OH-Pc-Co : | 2,3,9,10,16,17,23,24-octahydroxyphthälöcyaninato)cobalt |
| Pa-1 : | *p*-phenylendiamine |
| Pa-2 : | 2,5-dimethyl- *p*-phenylendiamine |
| PA : | piperazine |
| Pac : | 2-propenyl acetate |
| PcTA : | phthalocyanine tetra(acetonide) |
| PdAc : | palladium acetate |
| PDBA : | pyrenediboronic acid |
| PPE : | phenylbis(phenylethynyl) diboronic acid |
| PPP : | 3-phenyl-1-propyne propiolate |
| PyMP : | (3α1,3α2-dihydropyren-1-yl)methyl propionate |
| PTBTBA : | para-tribromotribenzylaniline |
| TA : | terephthaldehyde |
| TAM : | tetra-(4-anilyl)methane |
| TAPP : | tetra(p-amino-phneyl)porphyrin |
| TAzM : | tetrakis(4-azidophenyl)-methane |
| TBB : | 1,3,5-tris(4-bromophenyl)benzene |
| TBPA : | tetrakis(4-bromophenyl)adamantane |
| TBPGe : | tetra (4-dihydroxyborylphenyl)germanium |
| TBPM : | tetra(4-dihydroxyboryl-phenyl)methane |
| TBPP : | tetra(p-boronic acid-phenyl)porphyrin |
| TBPS : | tetra (4-dihydroxyboryl-phenyl) silane |
| TBrB : | 1,3,5-tribromoberizene |
| TBST : | tert-butylsilane triol |
| TCM : | tetrakis(4-cyanophenyl)methane |
| TCPSi : | tetrakis (4-cyanophenyl) silica |
| TDHB-ZnP : | zinc(II) 5,10,15,20-tetrakis(4-(dihydroxyboryl)phenyl)porphyrin |
| TDHB-CuP : | copper 5,10,15,20-tetrakis(4-(dihydroxyboryl)phenyl)porphyrin |
| TEB : | 1,3,5-triethynylbenzene |
| TEM : | tetrakis(4-ethynyl)methane |
| TEPA : | tetrakis(4-ethynylphenyl)adamantane |
| TEPM : | tetrakis(4-ethynylphenyl)methane |
| TFB : | 1,3,5-triformylbenzene |
| TFPB : | 1,3,5-tris-(4-formyl-phenyl)-benzene |
| THAn : | 2,3,4,5-tetrahydroxy anthracene |
| THB : | 1,2,4,5-tetrahydroxybenzene |
| THDMA : | polyol 2,3,6,7-tetrahydroxy-9,10-dimethyl-anthracene |
| TIPB : | 1,3,5-tris(4'-iodophenyl)benzene |
| TkBPM : | tetrakis(4-bromophenyl)methane |
| TMC : | benzene-1,3,5-tricarbonyltrichloride |
| Tp : | 1,3,5-triformylphloroglucinol |
| TPB : | 1,3,5-tris(4-hydroxyphenyl)benzene |
| TPTA : | triphenylene tris(acetonide) |
| TTPAP-CuP : | copper 5,10,15,20-tetrakis(p-tetraphenylamino)porphyrin |
| trunc-TBPM-R : | R-functionalized truncated TBPM |

Die Erfindung wird im Folgenden anhand von Ausführungsbeispielen und den Figuren näher erläutert. Hierbei zeigen:
- **Fig. 1**: Schematischer Verfahrensablauf der Herstellung einer Schicht aus mehreren Lagen zwei verschiedener Verbindungen A und B auf einer Opferschicht
- **Fig. 2**: Rasterelektronenmikroskopaufnahme einer POF-Membran auf einem Kupfernetz nach Ausführungsbeispiel 2.
- **Fig. 3**: Herstellung von unterschiedlich porösen Schichten innerhalb einer Folie aus mehreren Lagen verschiedener Verbindungen A-E auf einer Opferschicht.
- **Fig. 4**: Permeanz (P in Nm³m⁻²h⁻¹bar⁻¹) von acht verschiedenen Gasen mit Molekülen unterschiedlich großer kinetischer Durchmesser (Ø in Å) durch eine POF Nanomembran, die auf einer PAN/PDMS Stützmembran aufliegt (gefüllte Rauten) im Vergleich zu der PAN/PDMS Stützmembran (gefüllte Dreiecke).
- **Fig. 5**: Selektivität (S in Gas x/H₂) der POF Nanomembran (gefüllte Rauten) von H₂ gegenüber sieben verschiedenen Gasen mit Molekülen unterschiedlich großer kinetischer Durchmesser (Ø in Å).

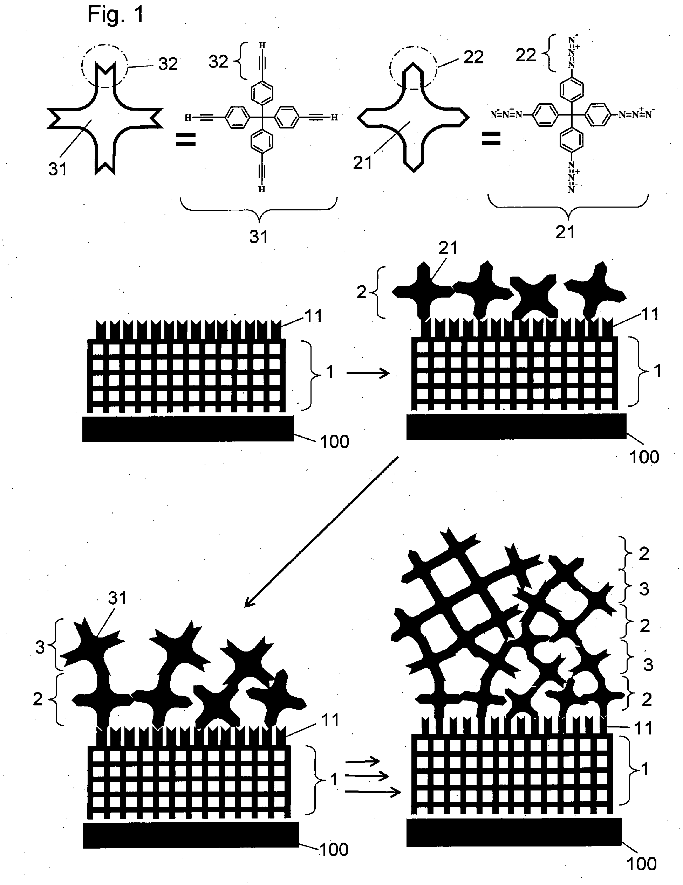

In **Fig. 1** ist der Aufbau einer Schicht aus zwei verschiedenen Lagen auf einer Opferschicht schematisch dargestellt. Die Verbindungen X der Opferschicht (1) sind auf einem Substrat (100) aufgebracht und mit funktionellen Gruppen (11) versehen. Die funktionellen Gruppen (11) der Verbindungen X der Opferschicht sind komplementär zu den funktionellen Gruppen (22) der Verbindungen A (21) der ersten Lage (2), welche ebenfalls komplementär zu den funktionellen Gruppen (32) der Verbindungen B (31) der zweiten Lage (3) sind. Auf die Opferschicht (1) wird nun abwechselnd jeweils eine Lage der Verbindungen A (21) der ersten Lage (2) und eine Lage der Verbindungen B (31) der zweiten Lage (3) aufgebracht, bis die gewünschte Dicke der Folie erreicht ist.

Anschließend wird die Opferschicht (1) aufgelöst (12) und man erhält die freistehende POF-Membran (4).

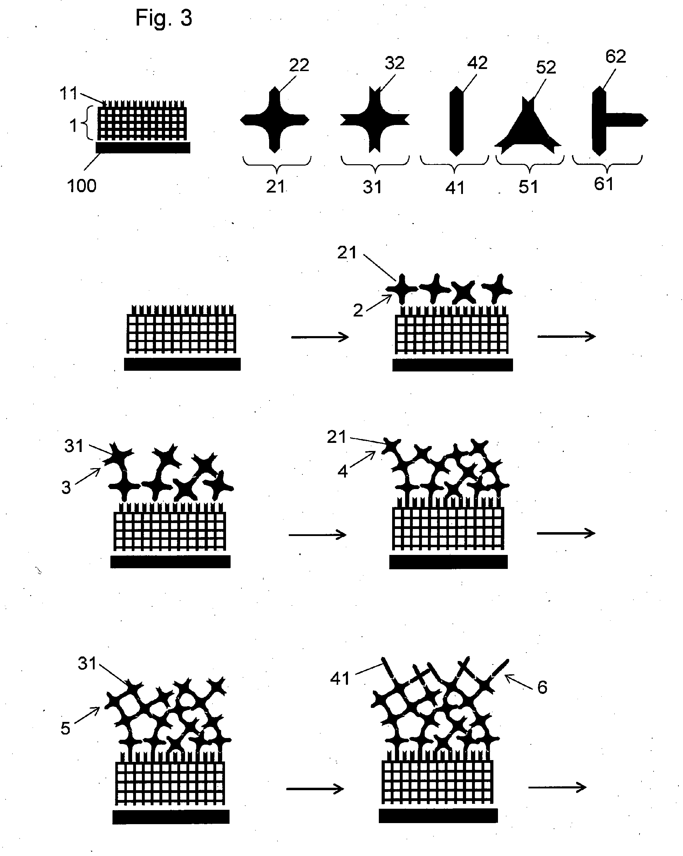

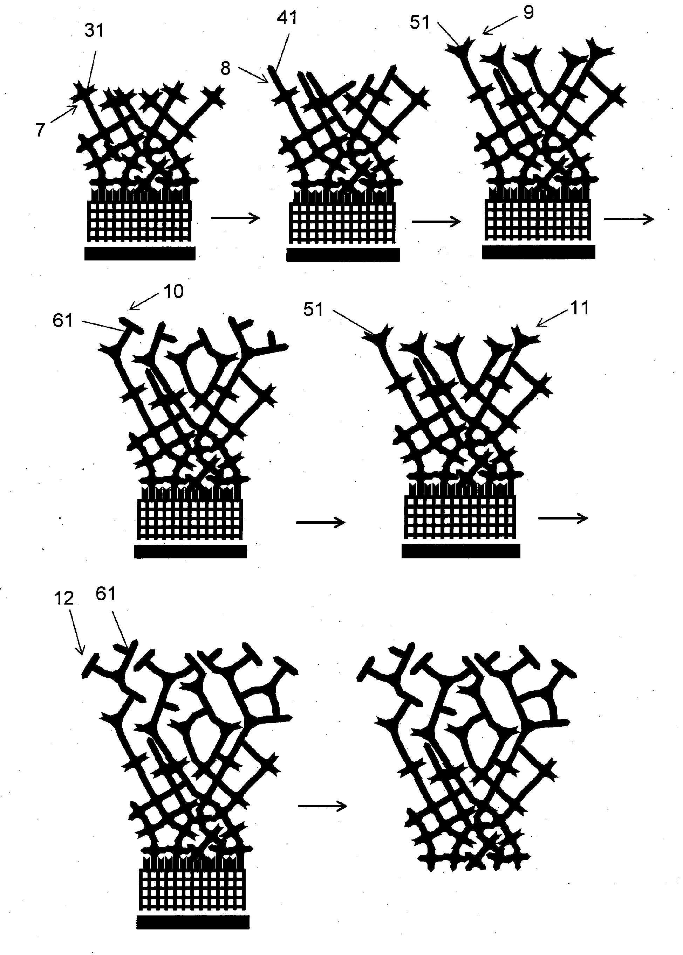

**Fig. 3** zeigt eine Rasterelektronenmikroskopaufnahme einer freistehenden POF-Membran auf einem Kupfernetz. Die POF-Membran besteht aus 8 Schichten der Verbindungen Tetrakis(4-azidophenyl)-methan) und Tetrakis(4-ethinylphenyl)methan).

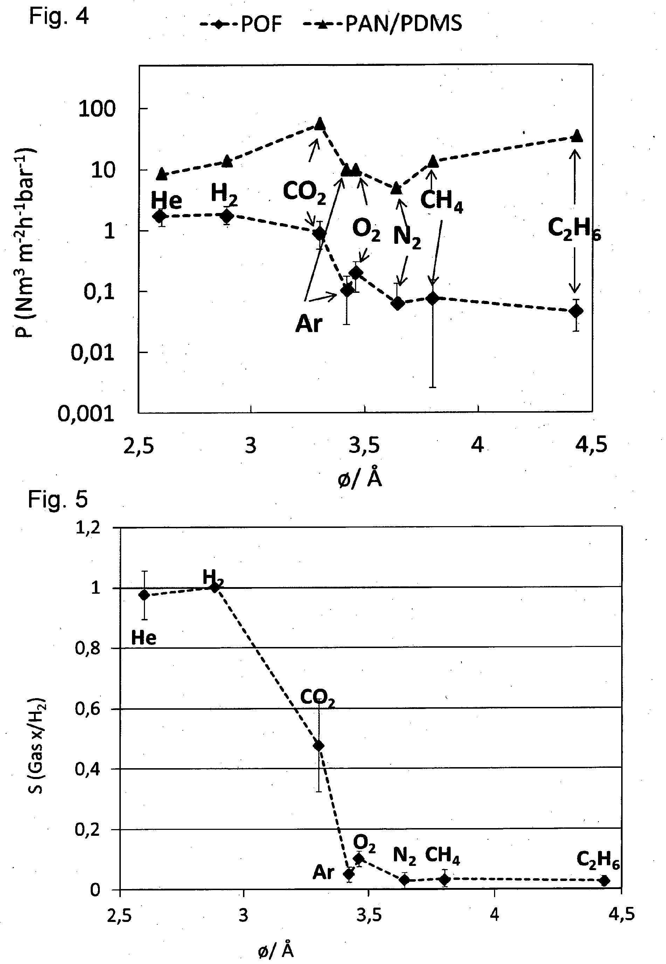

In **Fig. 4** ist der Aufbau einer Schicht aus 5 verschiedenen Lagen auf einer Opferschicht schematisch dargestellt. Die Verbindungen X der Opferschicht (1) sind auf einem Substrat (100) aufgebracht und mit funktionellen Gruppen (11) versehen. Die funktionellen Gruppen (11) der Verbindungen X der Opferschicht sind komplementär zu den funktionellen Gruppen (22) der Verbindungen A (21) der ersten Lage (2), welche ebenfalls komplementär zu den funktionellen Gruppen (32) der Verbindungen B (31) der zweiten Lage (3) sind. Auf die Opferschicht (1) wird nun zweimal abwechselnd jeweils eine Lage der Verbindungen A (21) der ersten Lage (2) und eine Lage der Verbindungen B (31) der zweiten Lage (3) aufgebracht, bis die gewünschte Dicke der Folie erreicht ist. Auf die zweite Lage der Verbindung B (31) der zweiten Lage (3) wird als nächstes eine Lage der Verbindung C (51), deren funktionelle Gruppen komplementär zu den funktionellen Gruppen der Verbindung B (31) sind, aufgebracht. Darauf wird eine Lage der Verbindung B (31) aufgebracht und erneut eine Lage der Verbindung C (41). Nun wird als nächstes eine Lage der Verbindung D (51), deren funktionelle Gruppen komplementär zu den funktionellen Gruppen der Verbindung C (41) sind aufgebracht. Darauf wird eine Lage der Verbindung E (61), deren funktionelle Gruppen komplementär zu den funktionellen Gruppen der Verbindung D (51) sind aufgebracht. Anschließend wird eine Lage der Verbindung D (61) aufgebracht und erneut eine Lage der Verbindung E (61). Anschließend wird die Opferschicht (1) aufgelöst und man erhält die freistehende POF-Membran (4).

### Ausführungsbeispiel 1: Herstellung POF-Membran (16 Lagen) auf einem N₃ funktionalisierten SURMOF.

Es wurde zunächst eine Opferschicht bestehend aus einem N3 funktionalisierten SURMOF hergestellt. Die SURMOF wurden wie in Literatur (M. Tsotsalas et al. J. Am. Chem. Soc. 2014, 136, 8-11) beschrieben synthetisiert. Dabei wurden 10 Lagen SURMOF bestehend aus Kupfer(II)acetat als Metallzentren und 2,2'-diazido-4,4'-stilbenedicarboxylic acid (DA-SBDC) hergestellt. Die N₃-Funktionen dienen im layer-by-layer Verfahren (LbL) als Anknüpfungspunkte für die kovalente Anknüpfung der Komponente A (in diesem Beispiel Tetrakis(4-ethinylphenyl)methan) über eine Kupfer-katalysierte Alkin-Azid Kupplung. Im Anschluss wird dann die Komponente B (in diesem Beispiel Tetrakis(4-azidophenyl)-methan)an nicht abreagierte Ethinyl-Funktionen der Komponente A gebunden. Fig. 1 zeigt die Bausteine A und B und eine schematische Darstellung der LbL Synthese. Vor jedem Schritt wurde ein Kupferkatalysator zugegeben (Tetrakis-acetonitrile-copper(I) hexafluorophosphate). Die Synthese fand unter Schutzgas (N₂) statt. Nach jedem Schritt wurde das Substrat ausgiebig mit THF gespült. TPM.-azid, TPM-alkin und Tetrakis(acetonitril)Kupfer(I) hexafluorophosphat wurden in 25 mL wasserfreiem THF (c = 2 mmol/L) gelöst. Die Synthese wurde unter Schutzgas (N₂) mittels Schlenktechnik durchgeführt. TPMazid und TPM-alkin wurden jeweils mit Cu(I)Katalysator versetzt und alternierend zum Substrat gegeben.- Nach jedem Schritt wurde das Substrat mit THF gespült. Die Reaktion wurde bei 40 °C für 30 Minuten durchgeführt.

### 2. Herstellung einer freistehenden POF-Membran und Analyse der Permeanz für Gase

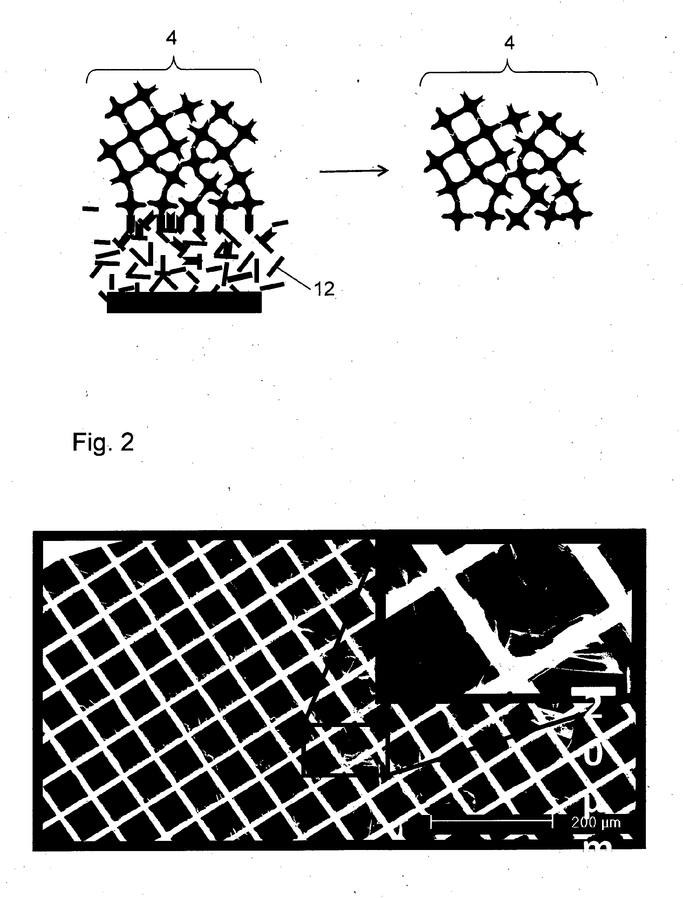

Nach wenigen Minuten einlegen der SURMOF/POF Membran aus Ausführungsbeispiel 1 (2×2 cm) in einer Lösung aus 1 mg EDTA in 10 mL Ethanol/Wasser (1/1 nach Volumen) lässt sich so die POF Schicht isolieren. Die freie POF Membran, kann dann beispielsweise mit einem TEM Netz aufgefischt werden. Die SEM Aufnahmen der aufgefischten Membran ist in Fig. 2 gezeigt.

Für Gastrennungsanwendungen wurde die freistehende POF Membran auf einen.PAN/PDMS Stützmembran (Yave et al., Nanotechnologie (2019) 395301) übertragen. Anschließend wurden 8 verschiedene Gase (Helium, Wasserstoff, Kohlenstoffdioxid, Argon, Sauerstoff, Stickstoff, Methan und Ethan) auf deren Permeanz getestet. Die Permeanz der Gase wurde bei einem Einspeisungsdruck zwischen 108 und 280 mbar und bei einer Temperatur von 30°C mittels eines konstantes Volumen/variabler Druck experimentellen Aufbau (A. M. Shishatskii et al. Journal of,Membrane Science 1996, 112, 275-285) gemessen.

**Tabelle 2: Ergebnisse der Analyse der Permeanz verschiedener Gase durch die POF-Membran**

| Gas | Durchmesser (Å) | Permeanz (Nm3 m-2h-1bar-1) |
|---|---|---|
| Helium | 2,6 | 1,72 |
| Wasserstoff | 2,89 | 1,86 |
| Kohlenstoffdioxid | 3,3 | 0,93 |
| Argon | 3,42 | 0,10 |
| Sauerstoff | 3,46 | 0,20 |
| Stickstoff | 3, 64 | 0,06 |
| Methan | 3,8 | 0,08 |
| Ethan | 4,43 | 0,046 |

Fig. 4 zeigt die Permeanz von acht verschiedenen Gasen mit Molekülen unterschiedlich großer kinetischer Durchmesser durch eine POF Nanomembran, aufliegend auf einer PDMS Stützmembran, im Vergleich zu der PDMS Stützmembran. Die Ergebnisse zeigen deutlich dass die Permeanz der verschiedenen Gase durch die POF Membran stark von dem Kinetischen Durchmesser der Gase abhängt (im Gegensatz zur PDMS Stützmembran alleine, bei welcher die Permeanz von den Adsorptions- und Diffusionseigenschaften der Gase durch die Membran abhängt). Fig. 5 zeigt die Selektivität der POF Nanomembran von H₂ gegenüber sieben verschiedenen Gasen mit Molekülen unterschiedlich großer kinetischer Durchmesser. Die Ergebnisse zeigen deutlich, dass die erhaltene Membran als Molekularsieb verwendet werden kann.

### Ausführungsbeispiel 3: Herstellung weiterer POF-Membran (16 Lagen) auf einem N₃ funktionalisierten SURMOF.

Es wurde zunächst eine Opferschicht bestehend aus einem N₃ funktionalisierten SURMOF hergestellt. Die N₃-Funktionen dienen im layer-by-layerVerfahren (LbL) als Anknüpfungspunkte für die kovalente Anknüpfung der Komponente A (siehe Tabelle 3) über eine Kupfer-katalysierte Alkin-Azid Kupplung. Im Anschluss wird dann die Komponente B (Tetrakis(4-azidophenyl)-methan) an nicht abreagierte Ethinyl-Funktionen der Komponente A gebunden. FVor jedem Schritt wurde ein Kupferkatalysator zugegeben (Tetrakis-acetonitrile-copper(I) hexafluorophosphate). Die Synthese fand unter Schutzgas (N₂) statt. Nach jedem Schritt wurde das Substrat ausgiebig mit THF gespült.

**Tabelle 3: Komponenten A der weiteren POF-Membranen aus Ausführungsbeispiel 3 mit jeweils 16 Lagen.**

| Experiment | Komponente A |
|---|---|
| 1 | 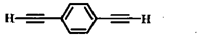 |
| 2 | 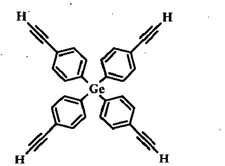 |
| 3 | 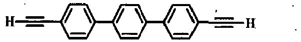 |
| 4 | 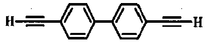 |
| 5 | 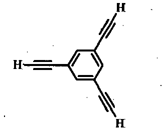 |
| 6 | 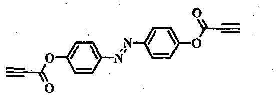 |

### Referenzen

G. Decher et al. Science 1997, 277, 1232-1237
Kim et al. Macromolecules, 2011, 44, 7092
Qian et al. Langmuir, 2012, 28, 17803
M. Tsotsalas et al. J. Am. Chem. Soc. 2014, 136, 8-11
A. M. Shishatskii et al. Journal of Membrane Science 1996, 112, 275-285

## Patentansprüche

1. Verfahren zur Herstellung von mikroporösen organischen POF- (Porous Organic Framework) Membranen, enthaltend mindestens zwei verschiedene organische Verbindungen, die aromatische Bausteine enthalten, wobei mindestens eine der organischen Verbindungen mindestens zwei funktionelle Gruppen und mindestens eine der weiteren organischen Verbindungen mindestens drei funktionelle Gruppen aufweist, mit den folgenden Verfahrensschritten:
a) Bereitstellen einer Opferschicht mit einer Vielzahl gleicher funktioneller Gruppen
b) Aufbringen einer ersten Lage einer ersten organischen Verbindung durch Reaktion mit den funktionellen Gruppen der Opferschicht
c) Aufbringen einer ersten Lage einer zweiten organischen Verbindung durch Reaktion mit mindestens einer der funktionellen Gruppen der organischen Verbindungen der ersten Lage
d) Auflösen der Opferschicht
e) Entnahme der POF-Membran,
wobei mindestens eine der funktionellen Gruppen einer Lage oder der Opferschicht mit mindestens einer der funktionellen Gruppen der nachfolgenden Lage reagiert und die funktionellen Gruppen der aufeinanderfolgenden Lagen komplementär sind und/oder durch Schutzgruppen geschützt sind,
wobei mehr als 2 verschiedene organische Verbindungen eingesetzt werden, um mehr als 2 verschiedene Lagen zu erzeugen,
wobei die Opferschicht aus einem MOF (Metal-Organic Framework) oder SURMOF (Surface Anchored Metal-Organic Framework) Material besteht,
wobei die POF-Membran freistehend ist und eine homogene, kontinuierliche Schichtdicke von mindestens 0,3 nm und eine Porengröße von 0,01 - 2 nm aufweist.

2. Verfahren nach Anspruch 1, wobei zwischen den Verfahrensschritten c) und d) folgende Verfahrensschritte erfolgen
c i) Aufbringen einer weiteren Lage der ersten oder einer weiteren organischen Verbindung, und
c ii) Aufbringen einer weiteren Lage einer weiteren organischen Verbindung mit mindestens zwei funktionellen Gruppen und/oder
c iii) Wiederholung der Schritte c, c i und/oder c ii, bis eine gewünschte Schichtdicke erreicht ist.

3. Verfahren nach Anspruch 2, wobei nach mindestens einem der Verfahrensschritte a), b), c), d), e) eine Aktivierung der funktionellen Gruppe der jeweils zuletzt aufgebrachten Lage erfolgt.

4. Verfahren nach einem der Ansprüche 1 bis 3, wobei die Reaktionen der Verfahrensschritte b-f zu kovalenten Bindungen führen.

5. Verfahren nach einem der Ansprüche 1 bis 4, wobei die Reaktionen der Verfahrensschritte b-f ausgewählt sind unter Trimerisierung von Isocyanatgruppen, Kondensation von Alkoholen und Carbonsäurechloriden, Kupplungsreaktionen, nucleophile Substitutionen, Kreuzkupplungsreaktionen, Click-Chemie-Reaktionen.

6. Verfahren nach einem der Ansprüche 1 bis 5, wobei Verfahrensschritt e) durch eine Veränderung des pH-Werts oder durch Zugabe eines Komplexbildners erfolgt.

7. Mikroporöse organische POF-Membran, hergestellt nach einem Verfahren der Ansprüche 1 bis 6.

8. Verwendung der nach einem der Ansprüche 1 bis 6 hergestellten POF-Membran für die Gastrennung, die Wasseraufbereitung und/oder die Nanofiltration.

9. Verwendung der nach einem der Ansprüche 1 bis 6 hergestellten POF-Membran in Brennstoffzellen, Batterien und/oder für die chemische Katalyse.

10. Verwendung der nach einem der Ansprüche 1 bis 6 hergestellten POF-Membran in organischen Leuchtdioden (OLEDs), organischen Feldeffekttransistoren/Dünnschichttransistoren (OFET) und organischen Solarzellen (OPV).

## Claims

1. Method for the preparation of microporous organic POF (Porous Organic Framework) membranes, containing at least two different organic compounds, which contain aromatic modules, wherein at least one of the organic compounds comprises at least two functional groups and at least one of the other organic compounds comprises at least three functional groups, with the following method steps:
a) preparing a sacrificial coating with a multiplicity of identical functional groups
b) applying a first layer of an organic compound by reaction with the functional groups of the sacrificial coating
c) applying of a first layer of a second organic compound by reaction with at least one of the functional groups of the organic compounds of the first layer
d) dissolving the sacrificial coating
e) removing of the POF membrane
wherein at least one of the functional groups of a layer or of the sacrificial coating reacts with at least one of the functional groups of the subsequent layer, and the functional groups of the sequential layers are complementary and/or are protected by protective groups,
wherein more than two different organic compounds are used in order to produce more than two different layers,
wherein the sacrificial coating consists of an MOF (Metal-Organic Framework) or SURMOF (Surface Anchored Metal-Organic Framework) material,
wherein the POF membrane is free-standing and comprises a homogeneous continuous coating thickness of at least 0.3 nm and a pore size of 0.01 - 2 nm.

2. Method according to claim 1, wherein the following method steps take place between the method steps c) and d):
c i) applying a further layer of the first or of a further organic compound, and
c ii) applying a further layer of a further organic compound with at least two functional groups, and/or
c iii) repeating steps c, c i and/or c ii, until a desired coating thickness is obtained.

3. Method according to claim 2, wherein, after at least one of the method steps a), b), c), d), e), an activation of the functional group of the respective layer which was last applied takes place.

4. Method according to any one of claims 1 to 3, wherein the reactions of the method steps b-f lead to covalent compounds.

5. Method according to any one of claims 1 to 4, wherein the reactions of the method steps b-f are selected from the trimerisation of isocyanate groups, condensation of alcohols and carboxylic acid chlorides, coupling reactions, nucelophilic substitutions, cross-coupling reactions, click-chemical reactions,

6. Method according to any one of claims 1 to 5, wherein method step e) takes place by changing the pH value or by the addition of a complexing agent.

7. Microporous organic POF membrane prepared in accordance with a method from any one of claims 1 to 6.

8. Use of the POF membrane prepared in accordance with any one of claims 1 to 6 for gas separation, water preparation, and/or nanofiltration.

9. Use of the POF membrane prepared in accordance with any one of claims 1 to 6 in fuel cells, batteries, and/or for chemical catalysation.

10. Use of the POF membrane prepared in accordance with any one of claims 1 to 6 in organic light emitting diodes (OLEDs), organic field effect transistors/thin-layer transistors (OFET) and organic photovoltaic solar cells (OPV).

## Revendications

1. Procédé de fabrication de membranes organiques microporeuses (membranes POF) (Porous Organic Framework) comportant au moins deux liaisons organiques différentes avec des briques aromatiques,
au moins l'une des liaisons organiques a au moins deux groupes fonctionnels et au moins l'une des autres liaisons organiques a trois groupes fonctionnels,
procédé comprenant les étapes suivantes consistant à :
a) fournir une couche sacrificielle avec un grand nombre de groupes fonctionnels identiques,
b) appliquer une première couche comprenant une première liaison organique par réaction avec les groupes fonctionnels de la couche sacrificielle,
c) appliquer une première couche comprenant une seconde liaison organique par réaction avec au moins l'un des groupes fonctionnels des liaisons organiques de la première couche,
d) dissoudre la couche sacrificielle,
e) prélever la membrane POF,
au moins l'un des groupes fonctionnels d'une couche ou de la couche sacrificielle réagissant avec au moins l'un des groupes fonctionnels de la couche suivante et les groupes fonctionnels des couches successives sont complémentaires et/ou sont soutenus par les groupes de protection,
* on utilise au moins plus de deux liaisons organiques différentes pour générer plus de deux couches différentes,
* la couche sacrificielle est une couche MOF (trame organique-métal) ou SURMOF (surface à accrochage de trame organique-métal), et
* la membrane POF est dégagée et a une épaisseur de couche continue d'au moins 0,3 nm et une dimension de pores de 0,01-2 nm.

2. Procédé selon la revendication 1,
selon lequel
entre les étapes c) et d) on effectuer les étapes suivantes :
c i) appliquer une autre couche de la première liaison organique ou d'une autre liaison organique, et
c ii) appliquer une autre couche d'une autre liaison organique avec au moins deux groupes fonctionnels, et/ou
c iii) répéter les étapes c, c i et/ou c ii, jusqu'à obtenir l'épaisseur de couche souhaitée.

3. Procédé selon la revendication 2,
selon lequel
dans au moins l'une des étapes a), b), c), d), e) on active les groupes fonctionnels de la dernière couche appliquée.

4. Procédé selon l'une des revendications 1 à 3,
selon lequel
les réactions des étapes b-f aboutissent à des liaisons covalentes.

5. Procédé selon l'une des revendications 1 à 4,
selon lequel
on sélectionne les réactions des étapes b-f parmi les réactions suivantes :
trimérisation des groupes isocyanate, condensation d'alcool et de chlorure d'acide carbonique, réaction de couplage, substitutions nucléo-philes, réactions de couplage croisé, réactions de chimie-clic.

6. Procédé selon l'une des revendications 1 à 5,
selon lequel
l'étape de procédé e) se fait par une modification du pH ou par addition d'un générateur de complexe.

7. Membrane organique microporeuse POF fabriquée selon un procédé des revendications 1 à 6.

8. Application d'une membrane POF fabriquée selon l'une des revendications 1 à 6 pour la séparation gazeuse, la préparation d'eau et/ou la nanofiltration.

9. Application d'une membrane POF fabriquée selon les revendications 1 à 6, pour des piles à combustible, des batteries et/ou l'analyse chimique.

10. Application d'une membrane POF réalisée selon l'une des revendications 1 à 6, à des diodes lumineuses organiques (OLED) des transistors à effet champ organiques / transistors à couches minces (OFET) ou des piles solaires organiques (OPV).
